# EUROPÄISCHE PATENTANMELDUNG

(11) **EP 4 697 528 A1**
(43) Veröffentlichungstag der Anmeldung: **18.02.2026**
(21) Anmeldenummer: 25191346.3
(22) Anmeldetag: 23.07.2025
(51) Int. Cl.: H01S 5/06, G01S 17/00, H01S 5/0683

(54) **VERFAHREN ZUM INITIALISIEREN EINES LASER-SYSTEMS**

(30) Priorität: 07.08.2024 DE 102024207469
(71) Anmelder: Robert Bosch GmbH, 70442 Stuttgart (DE)
(72) Erfinder: Copeto, David, 71638 Ludwigsburg (DE); Noe, Stefan, 70563 Stuttgart (DE); Hoffarth, Joern, 72764 Reutlingen (DE)

(57) **Zusammenfassung**

Die Erfindung betrifft ein Verfahren (100) zum Initialisieren eines Laser-Systems (1), umfassend die nachfolgenden Schritte:
- Auslesen (101) eines Wertes eines Integralanteils einer Laserregelung des Laser-Systems (1) vor einem Ausschalten des Laser-Systems (1),
- Ausschalten (102) des Laser-Systems (1),
- Initialisieren (103) des Laser-Systems (1) bei einem erneuten Starten mit dem ausgelesenen Wert, wobei hierzu der ausgelesene Wert in einem Initialisierungsregister (6) für den Integralanteil der Laserregelung verwendet wird.

Ferner betrifft die Erfindung ein Computerprogramm, eine Vorrichtung sowie ein Speichermedium zu diesem Zweck.

## Beschreibung

Die Erfindung betrifft ein Verfahren zum Initialisieren eines Laser-Systems. Ferner betrifft die Erfindung ein Computerprogramm, eine Vorrichtung sowie ein Speichermedium zu diesem Zweck.

### Stand der Technik

Die schnelle Erreichung der Nennleistung eines Laser-Systems beim Starten ist von zentraler Bedeutung für zahlreiche Anwendungen, die auf präzise und effiziente Lasertechnologie angewiesen sind. Verzögerungen beim Hochfahren können zu erheblichen Effizienzverlusten, erhöhten Betriebskosten und möglichen Qualitätseinbußen führen. Ein Laser-System, das schnell seine Nennleistung erreicht, minimiert Ausfallzeiten und ermöglicht eine sofortige Einsatzbereitschaft.

Um eine maximal zulässige Laserleistung nutzen zu können, muss insbesondere präzise und ohne Überschwinger geregelt werden. Nach dem Einschalten kann es einige Millisekunden dauern, bis die Laserleistung ihre Nennleistung erreicht und der Messablauf starten kann. Die Ausgangspannung, bei der die Nennleistung erreicht wird, ist abhängig von Temperatur und Bauteiltoleranzen, sodass ein einheitliches Einstellen in einer Fertigung nicht möglich ist.

### Offenbarung der Erfindung

Gegenstand der Erfindung ist ein Verfahren mit den Merkmalen des Anspruchs 1, ein Computerprogramm mit den Merkmalen des Anspruchs 7, eine Vorrichtung mit den Merkmalen des Anspruchs 8 sowie ein computerlesbares Speichermedium mit den Merkmalen des Anspruchs 9. Weitere Merkmale und Details der Erfindung ergeben sich aus den jeweiligen Unteransprüchen, der Beschreibung und den Zeichnungen. Dabei gelten Merkmale und Details, die im Zusammenhang mit dem erfindungsgemäßen Verfahren beschrieben sind, selbstverständlich auch im Zusammenhang mit dem erfindungsgemäßen Computerprogramm, der erfindungsgemäßen Vorrichtung sowie dem erfindungsgemäßen computerlesbaren Speichermedium, und jeweils umgekehrt, so dass bezüglich der Offenbarung der Erfindung stets auch eine wechselseitige Bezugnahme möglich ist.

Gegenstand der Erfindung ist insbesondere ein Verfahren zum Initialisieren eines Laser-Systems, umfassend die nachfolgenden Schritte, wobei die Schritte wiederholt und/oder in einer bestimmten Reihenfolge durchgeführt werden können. Das Laser-System ist insbesondere ein Laser-Entfernungsmessgerät. Somit ist das Verfahren gemäß der Erfindung insbesondere für Anwendungen relevant, bei denen eine exakte Entfernungsmessung entscheidend ist. Durch die schnellere Erreichung der Nennleistung und die verbesserte Initialisierung des Laser-Systems können die Messungen präziser und effizienter erfolgen.

In einem ersten Schritt wird vorzugsweise ein Wert eines Integralanteils einer Laserregelung des Laser-Systems vor einem Ausschalten des Laser-Systems ausgelesen. Um den Wert des Integralanteils auszulesen, kann ein Ausgangssignal eines Messreglers abgegriffen werden. Dieses Signal kann dann in ein digitales Format umgewandelt und von einem Mikrocontroller erfasst werden. Der aktuelle Integralwert liegt vorzugsweise bereits in digitaler Form vor. Dabei kann es sinnvoll sein, einen reduzierten Wert von beispielsweise 90% zurückzuspielen, um ein Überschwingen zu vermeiden. Alternativ kann der Wert des Integralanteils durch Anwendung einer entsprechenden mathematischen Formel berechnet werden, die den Wert des Integrals des Reglerausgangssignals über die Zeit angibt. Denkbar wäre eine komplexe mathematische Formel, welche eine Temperatur und Pausenzeit berücksichtigt.

In einem weiteren Schritt wird das Laser-System vorzugsweise ausgeschaltet.

In einem weiteren Schritt wird das Laser-System vorzugsweise bei einem erneuten Starten mit dem ausgelesenen Wert initialisiert, wobei hierzu der ausgelesene Wert in einem Initialisierungsregister für den Integralanteil der Laserregelung verwendet wird. Das Initialisierungsregister kann ein Speicherbereich sein, der für eine Konfiguration und ein Setzen von Anfangsbedingungen des Laser-Systems beim Einschalten, bzw. Starten, verwendet werden kann.

Durch die Verwendung des Initialisierungsregisters gemäß der Erfindung kann sichergestellt werden, dass das Laser-System schnell und zuverlässig auf eine gewünschte Nennleistung hochfahren kann. Damit kann vorteilhaft eine Anlaufzeit des Laser-Systems signifikant reduziert werden. Durch die Initialisierung des Integralanteils der Laserregelung mit dem vorher ausgelesenen Wert kann der Laser somit schneller auf seine Nennleistung ansteigen. Dies ermöglicht insbesondere eine schnellere Durchführung der eigentlichen Messung und somit effizientere Nutzung des Laser-Systems.

Des Weiteren kann vorgesehen sein, dass das Initialisieren des Laser-Systems ferner den folgenden Schritt umfasst:
- Überprüfen der Laserregelung auf Basis wenigstens eines Stabilitätsindikators, wobei der wenigstens eine Stabilitätsindikator eine Stabilität einer Laserleistung des Laser-Systems anhand eines vorgegebenen Wertebereichs bewertet.

Dadurch wird insbesondere erreicht, dass die Stabilität der Laserleistung vor dem Beginn der Messung beurteilt wird. Ein Mikrocontroller des Laser-Systems kann auf Basis des Stabilitätsindikators entscheiden, ob das Laser-System für eine zuverlässige Messung bereit ist. Dies kann eine Genauigkeit von anschließend erfassten Messdaten erhöhen und fehlerhafte Messungen verhindern oder zumindest reduzieren.

Ein weiterer Vorteil im Rahmen der Erfindung ist erzielbar, wenn das Initialisieren des Laser-Systems ferner den folgenden Schritt umfasst:
- Abbrechen des Startens, d.h. insbesondere des erneuten Startens, wenn ein Ergebnis des Überprüfens eine geringe Stabilität indiziert, wobei die geringe Stabilität auf Basis des vorgegebenen Wertebereich des wenigstens einen Stabilitätsindikators festgestellt wird.

Auf diese Weise ist es möglich, dass ein fehlerhaftes Verhalten des Lasersystems erkannt und verhindert wird. Die Erkennung geringer Stabilität ermöglicht eine frühzeitige Intervention und verhindert somit potenziell schädliche Auswirkungen auf die Messgenauigkeit oder das Laser-System selbst.

Nach einer weiteren Möglichkeit kann vorgesehen sein, dass das Initialisieren des Laser-Systems ferner den folgenden Schritt umfasst:
- Starten eines Messvorgangs des Laser-Systems, wenn ein Ergebnis des Überprüfens eine ausreichend hohe Stabilität indiziert, wobei die ausreichend hohe Stabilität auf Basis des vorgegebenen Wertebereich des wenigstens einen Stabilitätsindikators festgestellt wird.

Es ist somit möglich, dass der Messvorgang erst nach einer Überprüfung des Stabilitätsindikators gestartet wird. Dieser Schritt kann sicherstellen, dass der Laser im stabilen Zustand läuft und eine zuverlässigere anschließende Messung gewährleistet ist.

Es ist ferner denkbar, dass der wenigstens eine Stabilitätsindikator einen zulässigen Bereich für den Integralanteil der Laserregelung und/oder einen zulässigen Bereich für die Laserleistung vorgibt. Alternativ kann, insbesondere auf Basis zweier unterschiedlich großer Zahlenräume, eine Regelabweichung von einem Zielwert durch den Stabilitätsindikator vorgegeben werden. Es ist somit möglich, dass ein definierter Wertebereich für den Integralanteil der Laserregelung und/oder die Laserleistung festgelegt wird. Dieser Wertebereich dient insbesondere als Referenz. Durch diesen vorgegebenen Wertebereich kann ein Mikrocontroller bei dem Initialisieren des Laser-Systems präzise beurteilen, ob beispielsweise die Laserleistung innerhalb akzeptabler Grenzen liegt. Ein solcher vorgegebener Wertebereich kann eine zuverlässigere Initialisierung des Laser-Systems ermöglichen und eine Wahrscheinlichkeit von Instabilitäten während des Messablaufs reduzieren.

Ebenfalls Gegenstand der Erfindung ist ein Computerprogramm, insbesondere Computerprogrammprodukt, umfassend Befehle, die bei der Ausführung des Computerprogrammes durch einen Computer diesen veranlassen, das erfindungsgemäße Verfahren auszuführen. Damit bringt das erfindungsgemäße Computerprogramm die gleichen Vorteile mit sich, wie sie ausführlich mit Bezug auf ein erfindungsgemäßes Verfahren beschrieben worden sind.

Ebenfalls Gegenstand der Erfindung ist eine Vorrichtung zur Datenverarbeitung, die eingerichtet ist, das erfindungsgemäße Verfahren auszuführen. Als die Vorrichtung kann bspw. ein Computer vorgesehen sein, welcher das erfindungsgemäße Computerprogramm ausführt. Der Computer kann wenigstens einen Prozessor zur Ausführung des Computerprogramms aufweisen. Auch kann ein nicht-flüchtiger Datenspeicher vorgesehen sein, in welchem das Computerprogramm hinterlegt und von welchem das Computerprogramm durch den Prozessor zur Ausführung ausgelesen werden kann. Die Vorrichtung kann auch eine analoge diskrete elektronische Schaltung oder eine integrierte elektronische Schaltung sein, die entsprechend eingerichtet ist, das erfindungsgemäße Verfahren auszuführen.

Ebenfalls Gegenstand der Erfindung kann ein computerlesbares Speichermedium sein, welches das erfindungsgemäße Computerprogramm aufweist und/oder Befehle umfasst, die bei der Ausführung durch einen Computer diesen veranlassen, das erfindungsgemäße Verfahren auszuführen. Das Speichermedium ist bspw. als ein Datenspeicher wie eine Festplatte und/oder ein nicht-flüchtiger Speicher und/oder eine Speicherkarte ausgebildet. Das Speichermedium kann z. B. in den Computer integriert sein.

Darüber hinaus kann das erfindungsgemäße Verfahren auch als ein computerimplementiertes Verfahren ausgeführt sein. Alternativ oder zusätzlich kann zumindest einer der offenbarten Verfahrensschritte computer-implementiert sein und/oder automatisiert durchgeführt werden.

Weitere Vorteile, Merkmale und Einzelheiten der Erfindung ergeben sich aus der nachfolgenden Beschreibung, in der unter Bezugnahme auf die Zeichnungen Ausführungsbeispiele der Erfindung im Einzelnen beschrieben sind. Dabei können die in den Ansprüchen und in der Beschreibung erwähnten Merkmale jeweils einzeln für sich oder in beliebiger Kombination erfindungswesentlich sein. Es zeigen:
- Fig. 1: eine schematische Visualisierung eines Verfahrens, einer Vorrichtung, eines Speichermediums sowie eines Computerprogramms gemäß Ausführungsbeispielen der Erfindung,
- Fig. 2: eine schematische Darstellung eines Laser-Systems gemäß Ausführungsbeispielen der Erfindung.

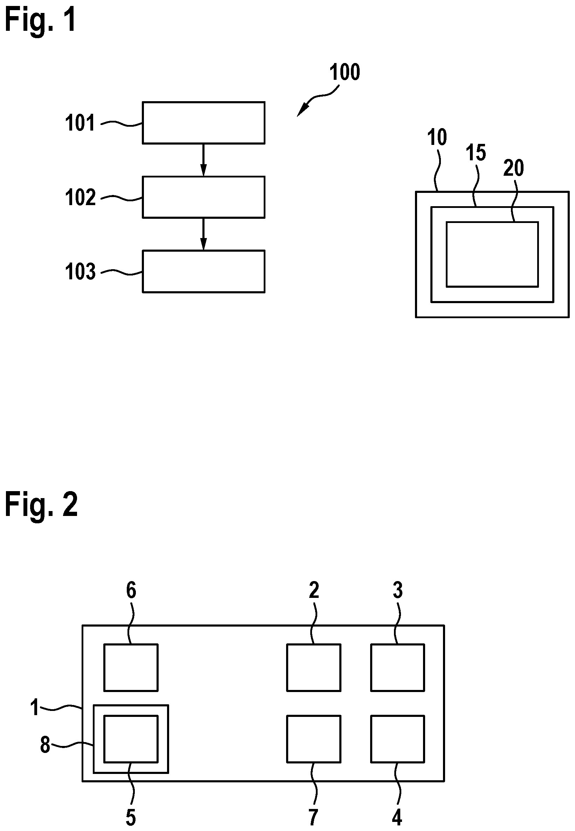

In Fig. 1 sind ein Verfahren 100, eine Vorrichtung 10, ein Speichermedium 15 sowie ein Computerprogramm 20 gemäß Ausführungsbeispielen der Erfindung schematisch dargestellt.

Fig. 1 zeigt insbesondere ein Ausführungsbeispiel für ein Verfahren 100 zum Initialisieren eines Laser-Systems 1. In einem ersten Schritt 101 wird ein Wert eines Integralanteils einer Laserregelung des Laser-Systems 1 vor einem Ausschalten des Laser-Systems 1 ausgelesen. In einem zweiten Schritt 102 wird das Laser-System 1 ausgeschaltet. In einem dritten Schritt 103 wird das Laser-System 1 bei einem erneuten Starten mit dem ausgelesenen Wert initialisiert, wobei hierzu der ausgelesene Wert in einem Initialisierungsregister 6 für den Integralanteil der Laserregelung verwendet wird.

Das Verfahren der vorliegenden Erfindung betrifft ein Laser-System 1 und gemäß Ausführungsbeispielen insbesondere ein Laser-Entfernungsmessgerät, das die indirekte Time of Flight (iToF)-Messung verwendet. Für dieses Ausführungsbeispiel sei auf Fig. 2 verwiesen. Dieses Laser-Entfernungsmessgerät 1 arbeitet beispielsweise mit einer Messung einer Phasenverschiebung eines modulierten Lichtsignals, das vom Laser-Entfernungsmessgerät ausgesendet und von einem Zielobjekt reflektiert wird. Im Folgenden wird die Funktionsweise der indirekten Time of Flight (iToF)-Messung beschrieben. Zunächst kann ein Laser 3, insbesondere eine Laserdiode des Lasers 3, im Laser-Entfernungsmessgerät 1 intensitätsmoduliertes Licht, beispielsweise im infraroten oder sichtbaren Bereich, in Richtung eines Zielobjekts senden. Die Modulation erfolgt insbesondere mit einer sinusförmigen oder Rechteckwelle. Das intensitätsmodulierte Licht trifft anschließend auf das Zielobjekt und wird zurück zum Laser-Entfernungsmessgerät 1 reflektiert. Ein Detektor 4 im Messgerät kann nun das reflektierte Licht empfangen. Da das Licht eine gewisse Zeit benötigt, um die Strecke hin und zurück zu legen, kommt es zu einer Phasenverschiebung zwischen dem ausgesendeten und dem empfangenen Signal. Diese Phasenverschiebung zwischen dem ausgesendeten und dem empfangenen Signal kann anschließend gemessen werden. Diese Phasenverschiebung ist insbesondere proportional zur zurückgelegten Entfernung des Lichts. Die Entfernung kann anschließend aus der Phasenverschiebung unter Berücksichtigung der Wellenlänge der Modulation und der Lichtgeschwindigkeit berechnet werden. Hierbei kann ferner vorgesehen sein, dass eine Referenzphase mit einem zweiten Detektor mit einem konstanten Abstand bestimmt wird (nicht dargestellt), um die Phasenverschiebung auf Basis eines Vergleiches mit der Referenzphase zu bestimmen.

Das Laser-Entfernungsmessgerät 1 kann einen Messregler 2 aufweisen. Der Messregler 2 übernimmt insbesondere die Laserregelung, d.h. beispielsweise eine Steuerung des Lasers 3.

So kann der Messregler 2 eine Emission des Lasers 3 steuern, indem er ein Ein- und Ausschalten sowie eine Intensität und die Modulation eines Laserstrahls des Lasers 3 regelt. Dadurch kann sichergestellt werden, dass der Laserstrahl mit der richtigen Leistung und den richtigen Eigenschaften ausgesendet wird.

Ferner kann ein Laserstrahl des Laser-Systems 1 moduliert werden, beispielsweise in Form von gepulstem Licht und/oder einer kontinuierlichen Welle mit variabler Modulationsfrequenz. Nach dem Empfang zumindest eines Bruchteils des ausgesendeten Laserlichts durch den Detektor 4 kann der Messregler 2 das empfangene Signal verarbeiten. Dies umfasst beispielsweise eine Verstärkung, Filterung und Umwandlung des empfangenen analogen Signals in ein digitales Signal zur weiteren Analyse, insbesondere durch einen Analog-Digital-Wandler 5. Ferner kann die Phasenverschiebung zwischen dem ausgesendeten und dem empfangenen Signal messen und gegebenenfalls mit der Referenzphase verglichen werden.

Der Messregler 2 kann ferner regelmäßig Kalibrierungen durchführen, um sicherzustellen, dass die Messungen präzise sind. Dafür kann er einen Zustand des Lasers 3 und des Detektors 4 überwachen, um sicherzustellen, dass diese ordnungsgemäß funktionieren.

Zudem kann das Laser-System 1, insbesondere das Laser-Entfernungsmessgerät, einen Analog-Digital-Wandler 5 aufweisen. Der Analog-Digital-Wandler 5 wandelt vorzugsweise analoge Signale, die vom Detektor 4 empfangen werden, in digitale Signale um. Diese Signale repräsentieren insbesondere eine Lichtintensität, die vom Laser 3 ausgesendet und vom Zielobjekt zurückgesendet wird. Die digitale Umwandlung kann es ermöglichen, die Phasenverschiebung zwischen dem ausgesendeten und dem empfangenen Signal zu analysieren. Die digitalen Signale, die von dem jeweiligen Analog-Digital-Wandler 5 bereitgestellt werden, können weiter gefiltert, verstärkt und verarbeitet werden, um Rauschen zu reduzieren und die Signalqualität zu verbessern.

Zudem kann das Laser-System 1 eine anwendungsspezifische integrierte Schaltung 8 aufweisen, in der beispielsweise der Analog-Digital-Wandler 5 angeordnet sein kann. Auch kann das Laser-System 1 einen Mikrocontroller 7 aufweisen, um unter Verwendung des Microcontrollers 7 die Laserregelung durchzuführen. Ferner kann das Laser-System 1 wenigstens ein Initialisierungsregister 6 aufweisen, um darin Daten zu speichern, wie beispielsweise den Wert des Integralanteils der Laserregelung.

Mit dem Verfahren gemäß Ausführungsbeispielen kann vorteilhaft eine Lasernennleistung schneller erreicht werden und damit eine eigentliche Messung schneller gestartet werden.

Vor dem Ausschalten des Lasers 3 wird dafür vorzugsweise ein Wert eines Integralanteils ausgelesen und bei dem nächsten Start in das Initialisierungsregister 6 des Integralanteils abgelegt. Durch Stabilitätsindikatoren (z.B. gekennzeichnet durch "Laser ok" und "Laser instabil") überprüft ein Mikrocontroller 7 des Laser-Systems 1 vorzugsweise beim Starten die Laserregelung. Basierend auf dem Ergebnis bricht der Mikrocontroller 7 insbesondere den Start ab oder kann direkt einen Beginn der Messung initiieren.

Die voranstehende Erläuterung der Ausführungsformen beschreibt die vorliegende Erfindung ausschließlich im Rahmen von Beispielen. Selbstverständlich können einzelne Merkmale der Ausführungsformen, sofern technisch sinnvoll, frei miteinander kombiniert werden, ohne den Rahmen der vorliegenden Erfindung zu verlassen.

## Patentansprüche

1. Verfahren (100) zum Initialisieren eines Laser-Systems (1), umfassend die nachfolgenden Schritte:
- Auslesen (101) eines Wertes eines Integralanteils einer Laserregelung des Laser-Systems (1) vor einem Ausschalten des Laser-Systems (1),
- Ausschalten (102) des Laser-Systems (1),
- Initialisieren (103) des Laser-Systems (1) bei einem erneuten Starten mit dem ausgelesenen Wert, wobei hierzu der ausgelesene Wert in einem Initialisierungsregister (6) für den Integralanteil der Laserregelung verwendet wird.

2. Verfahren (100) nach Anspruch 1,
**dadurch gekennzeichnet,**
**dass** das Initialisieren (103) des Laser-Systems (1) ferner den folgenden Schritt umfasst:
- Überprüfen der Laserregelung auf Basis wenigstens eines Stabilitätsindikators, wobei der wenigstens eine Stabilitätsindikator eine Stabilität einer Laserleistung des Laser-Systems (1) anhand eines vorgegebenen Wertebereichs bewertet.

3. Verfahren (100) nach Anspruch 2,
**dadurch gekennzeichnet,**
**dass** das Initialisieren (103) des Laser-Systems (1) ferner den folgenden Schritt umfasst:
- Abbrechen des Startens, wenn ein Ergebnis des Überprüfens eine geringe Stabilität indiziert, wobei die geringe Stabilität auf Basis des vorgegebenen Wertebereich des wenigstens einen Stabilitätsindikators festgestellt wird.

4. Verfahren (100) nach Anspruch 2 oder 3,
**dadurch gekennzeichnet,**
**dass** das Initialisieren (103) des Laser-Systems (1) ferner den folgenden Schritt umfasst:
- Starten eines Messvorgangs des Laser-Systems (1), wenn ein Ergebnis des Überprüfens eine ausreichend hohe Stabilität indiziert, wobei die ausreichend hohe Stabilität auf Basis des vorgegebenen Wertebereich des wenigstens einen Stabilitätsindikators festgestellt wird.

5. Verfahren (100) nach einem Ansprüche 2 bis 4,
**dadurch gekennzeichnet,**
**dass** der wenigstens eine Stabilitätsindikator einen zulässigen Bereich für den Integralanteil der Laserregelung und/oder einen zulässigen Bereich für die Laserleistung vorgibt.

6. Verfahren (100) nach einem der vorhergehenden Ansprüche,
**dadurch gekennzeichnet,**
**dass** das Laser-System (1) ein Laser-Entfernungsmessgerät ist.

7. Computerprogramm (20), umfassend Befehle, die bei der Ausführung des Computerprogramms (20) durch einen Computer (10) diesen veranlassen, das Verfahren (100) nach einem der vorhergehenden Ansprüche auszuführen.

8. Vorrichtung (10) zur Datenverarbeitung, die eingerichtet ist, das Verfahren (100) nach einem der Ansprüche 1 bis 6 auszuführen.

9. Computerlesbares Speichermedium (15), umfassend Befehle, die bei der Ausführung durch einen Computer (10) diesen veranlassen, die Schritte des Verfahrens (100) nach einem der Ansprüche 1 bis 6 auszuführen.
